# EUROPEAN PATENT APPLICATION

(11) **EP 2 597 685 A2**
(43) Date of publication of application: **29.05.2013**
(21) Application number: 12193639.7
(22) Date of filing: 21.11.2012
(51) Int. Cl.: H01L 31/068, H01L 31/18

(54) **Photovoltaic device and method of manufacturing the same**

(30) Priority: 23.11.2011 KR 20110123119
(71) Applicant: Samsung SDI Co., Ltd., Yongin-si, Gyeonggi-do (KR)
(72) Inventor: Kim, Tae-Jun, Chungcheongnam-do 331-300 (KR); Song, Min-Chul, Chungcheongnam-do 331-300 (KR); Kang, Yoon-Mook, Chungcheongnam-do 331-300 (KR); Lim, Heung-Kyoon, Chungcheongnam-do 331-300 (KR)
(74) Representative: Mounteney, Simon James

(57) **Abstract**

A method of manufacturing a photovoltaic device and a photovoltaic device manufactured by using the method is provided. The method comprises performing edge isolation to form a groove at an edge portion of a rear surface of a semiconductor substrate (optionally using a laser) and etching the damage layer formed during the edge isolation on the groove portion.

## Description

### BACKGROUND

### 1.Field

One or more embodiments of the present invention relate to a photovoltaic device and a method of manufacturing the photovoltaic device.

### 2. Description of Related Art

In order to manufacture a solar battery, a p-n junction is formed by doping an n-type (or p-type) dopant into a p-type (or n-type) substrate, and thus an emitter is formed. Electron-hole pairs formed by receiving light are separated, and then electrons are collected by an electrode of an n-type area, and holes are collected by an electrode of a p-type area, thereby generating electric power.

Since edge portions of a substrate are also doped with impurities during a process for forming a p-n junction, front and rear surface electrodes of a solar battery are electrically connected, thereby reducing the efficiency of the solar battery. Thus, edge isolation for electrically disconnecting front and rear surfaces needs to be performed.

### SUMMARY

The present invention provides a method of manufacturing a photovoltaic device as claimed in claims 1 to 9, a device produced by said method and a photovoltaic device as claimed in claims 11 to 17.

One or more embodiments of the present invention include a photovoltaic device and a method of manufacturing the photovoltaic device, in which a high concentration doping process and an edge isolation process may be concurrently (e.g., simultaneously) performed by using a laser.

Additional aspects will be set forth in part in the description that follows and, in part, will be apparent from the description, or may be learned by practice of the presented embodiments.

According to one or more embodiments of the present invention, a method of manufacturing a photovoltaic device includes forming a first conductive-type semiconductor layer using a first impurity on a semiconductor substrate, performing doping on a region of the first conductive-type semiconductor layer using a laser, performing edge isolation to form a groove portion at an edge portion of a rear surface of the semiconductor substrate, forming an antireflection layer on a front surface of the semiconductor substrate, forming a first metal electrode on the front surface of the semiconductor substrate, and forming a second metal electrode and a second conductive-type semiconductor layer including a second impurity that is different from the first impurity, on the rear surface of the semiconductor substrate.

The method may preferably further include etching a damage layer on the groove portion by using a byproduct layer as a mask, the byproduct layer being formed during formation of the first conductive-type semiconductor layer.

The etching may preferably include wet-etching the damage layer using an alkali solution.

The method may preferably further include removing the byproduct layer after the etching.

The region of the first conductive-type semiconductor layer may preferably correspond to the first metal electrode.

The method may preferably further include washing the front surface of the semiconductor substrate prior to forming the antireflection layer.

The washing may preferably include a first operation of removing impurities using a mixture solution including nitric acid and hydrofluoric acid, and a second operation of removing an oxide layer remaining after the first operation using diluted HF.

Forming the second metal electrode and the second conductive-type semiconductor layer may preferably include coating metallic pastes on the rear surface of the semiconductor substrate, and using a firing method to concurrently form the second metal electrode and the second conductive-type semiconductor layer.

According to another embodiment of the present invention, a photovoltaic device is manufactured using the above method.

According to one or more embodiments of the present invention, a photovoltaic device includes a semiconductor substrate, a first conductive-type semiconductor layer on a front surface of the semiconductor substrate and a lateral surface of the semiconductor substrate, the first conductive-type semiconductor layer being doped with a first impurity, a second conductive-type semiconductor layer on a rear surface of the semiconductor substrate, the second conductive-type semiconductor layer being doped with a second impurity that is different from the first impurity, and a groove portion at an edge portion of the semiconductor substrate that is configured to electrically isolate the first conductive-type semiconductor layer from the second conductive-type semiconductor layer, wherein a portion of the first conductive-type semiconductor layer is doped with the first impurity at a higher concentration than a remaining portion of the first conductive-type semiconductor layer.

Portions of the semiconductor substrate, the first conductive-type semiconductor layer, and the second conductive-type semiconductor layer are exposed to the outside through the groove portion.

The photovoltaic device may preferably further include a first metal electrode on a portion of the first conductive-type semiconductor layer.

The photovoltaic device may preferably further include an antireflection layer on the first conductive-type semiconductor layer.

The photovoltaic device may preferably further include a second metal electrode on the second conductive-type semiconductor layer, the second metal electrode including a same chemical element as that of the second impurity.

The semiconductor substrate may preferably be a second conductive-type.

The semiconductor substrate may preferably include a textured surface.

### BRIEF DESCRIPTION OF THE DRAWINGS

These and/or other aspects of embodiments of the present invention will become apparent and more readily appreciated from the following description of the example embodiments, taken in conjunction with the accompanying drawings of which:

FIG. 1 is a schematic cross-sectional view of a photovoltaic device according to an embodiment of the present invention;

FIG. 2 is a flowchart of a method of manufacturing a photovoltaic device, according to an embodiment of the present invention; and

FIGS. 3 through 11 are side views for describing states of operations described in the flowchart of FIG. 2, according to an embodiment of the present invention.

### DETAILED DESCRIPTION

Reference will now be made in detail to embodiments of the present invention, examples of which are illustrated in the accompanying drawings, wherein like reference numerals refer to like elements throughout. In this regard, the present embodiments may have different forms, and should not be construed as being limited to the descriptions set forth herein. Accordingly, the described embodiments are merely described below, by referring to the figures, to explain aspects of the present description. The terminology used herein is for the purpose of describing particular embodiments only, and is not intended to be limiting of the scope of the invention. As used herein, the singular forms "a," "an," and "the" are intended to include the plural forms as well, unless the context clearly indicates otherwise. It will be further understood that the terms "comprise" and/or "comprising," when used in this specification, specify the presence of stated features, integers, steps, operations, elements, and/or components, but do not preclude the presence or addition of one or more other features, integers, steps, operations, elements, components, and/or groups thereof. It will be understood that although the terms first and second are used herein to describe various elements, these elements should not be limited by these terms. These terms are only used to distinguish one element from another element. For convenience of understanding, same reference numerals denote same elements in the drawings.

In the drawings, lengths and sizes of layers and regions may be exaggerated for clarity. It will be understood that when an element, layer, or region is referred to as being "on" another element, layer, or region, the element, layer, or region can be directly on another element, layer, or region, or intervening elements, layers, or regions may also be present. In contrast, when an element is referred to as being "directly on" another element, layer, or region, there are no intervening elements, layers, or regions present. As used herein, the term "and/or" includes any and all combinations of one or more of the associated listed items. Expressions such as "at least one of," when preceding a list of elements, modify the entire list of elements and do not modify the individual elements of the list.

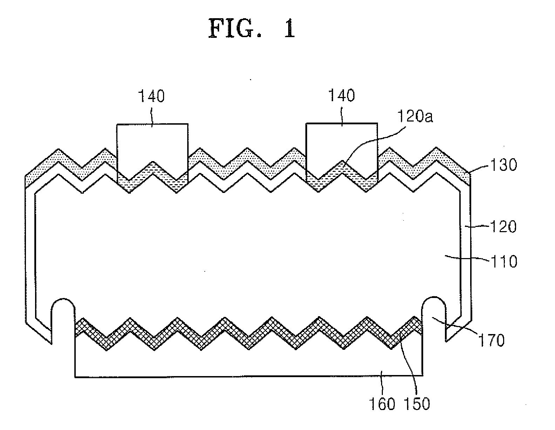

FIG. 1 is a schematic cross-sectional view of a photovoltaic device according to an embodiment of the present invention. Referring to FIG. 1, the photovoltaic device according to the present embodiment includes a semiconductor substrate 110, a first conductive semiconductor layer 120, an antireflection layer 130, a first metal electrode(s) 140, a second conductive semiconductor layer 150, and a second metal electrode 160. Groove portions 170 may be formed in edge portions of a rear surface of the photovoltaic device by an edge isolation process.

The semiconductor substrate 110 may be a light absorbing layer, and may preferably include a silicon substrate. For example, the semiconductor substrate 110 may be a p-type monocrystalline silicon substrate or a p-type polycrystalline silicon substrate.

At least one surface of a front surface and a rear surface of the semiconductor substrate 110 may preferably include a texture structure. An optical path of incident light may be increased by the texture structure, thereby increasing light absorption efficiency. Due to the textured surface of the semiconductor substrate 110, the first conductive semiconductor layer 120 and the antireflection layer 130 formed on the semiconductor substrate 110 may preferably also have an uneven surface.

The first conductive semiconductor layer 120 may preferably be formed to surround a front surface and a lateral surface(s) of the semiconductor substrate 110, and may preferably be doped with a first impurity, such as, for example, an n-type material. Examples of the first impurity may preferably include group 5 chemical elements, such as phosphorus (P) or arsenic (As). A p-n junction is formed by the first conductive semiconductor layer 120 together with the semiconductor substrate 110.

A portion 120a of the first conductive semiconductor layer 120 may preferably be doped with a high concentration of the first impurity, as compared to a remainder (e.g., remaining portion) of the first conductive semiconductor layer 120. The portion 120a of the first conductive semiconductor layer 120 doped with a high concentration of the first impurity may preferably be positioned just below the first metal electrode 140 (e.g., between the first metal electrode 140 and the semiconductor substrate 110) to reduce contact resistance with the first metal electrode 140, thereby increasing the electrical properties of the photovoltaic device.

The antireflection layer 130 may preferably be formed on the first conductive semiconductor layer 120, may preferably be light transmissive, and may prevent incident light from being reflected to reduce or prevent a loss in light absorption of the photovoltaic device, thereby increasing the efficiency of the photovoltaic device. For example, the antireflection layer 130 may preferably be formed of SiOx, SiNx, SiOxNy, or the like. Alternatively, the antireflection layer 130 may preferably be formed of TiOx, ZnO, ZnS, or the like.

The first metal electrode 140 of the present embodiment may preferably include silver (Ag), gold (Au), copper (Cu), aluminum (Al), or an alloy thereof, and may preferably also be electrically connected to an external device (not shown).

The second conductive semiconductor layer 150 is located on the rear surface of the semiconductor substrate 110, and is doped with a second impurity, such as, for example, a p-type material. Examples of the second impurity may preferably include group 3 chemical elements such as boron (B) or aluminum (Al). The second conductive semiconductor layer 150 may preferably be doped with a high concentration of the second impurity, as compared to the semiconductor substrate 110, and thus may be a p+ type or a p++ type. The second conductive semiconductor layer 150 forms a back surface field (BSF) so as to prevent holes and electrons from being recombined, and thus annihilated, around the second metal electrode 160.

According to an embodiment of the present invention, the second conductive semiconductor layer 150 may preferably include a metallic chemical element such as, for example, Al by using a manufacturing method that will be described below.

The second metal electrode 160 may preferably include, for example, Ag, Au, Cu, Al, or an alloy thereof, and may preferably be electrically connected to an external device (not shown).

The groove portions 170 may preferably be formed on the rear surface of the semiconductor substrate 110 spaced apart from two lateral ends of the semiconductor substrate 110. While an n-type material is doped to form the first conductive semiconductor layer 120, the front and rear surfaces of the semiconductor substrate 110 may preferably be electrically connected. Front and rear surfaces of the photovoltaic device are disconnected from each other by the groove portions 170, and thus the efficiency of the photovoltaic device may be increased. Through the groove portions 170, a portion of the semiconductor substrate 110 and portions of the first and second conductive semiconductor layers 120 and 150 may preferably be exposed.

The groove portions 170 may preferably be formed by using laser and chemical etching methods. The front and rear surface of the semiconductor substrate 110 are electrically insulated from each other by forming the groove portions 170 in the rear surface of the semiconductor substrate 110 to have a depth (e.g., a predetermined depth) by using a laser. When an edge isolation process is performed using a laser, a damage layer (not shown) is formed by a high temperature laser. The damage layer is an impurity layer melted by a laser, and then hardened. Since the damage layer reduces the efficiency of the photovoltaic device, the damage layer may preferably be removed using a chemical etching method by using, for example, an alkali solution. A process of forming the groove portions 170 will be described in detail below.

According to the above-described embodiment of the present invention, the semiconductor substrate 110 is a p-type silicon substrate, the first conductive semiconductor layer 120 is doped with an n-type material, and the second conductive semiconductor layer 150 is doped with a p-type material. However, the above-described embodiment of the present invention is not limited to this particular structure. For example, the semiconductor substrate 110 may preferably include an n-type silicon substrate, the first conductive semiconductor layer 120 may preferably be doped with a p-type material, and the second conductive semiconductor layer 150 may preferably be doped with an n-type material.

Hereinafter, a method of manufacturing a photovoltaic device according to an embodiment of the present invention will be described.

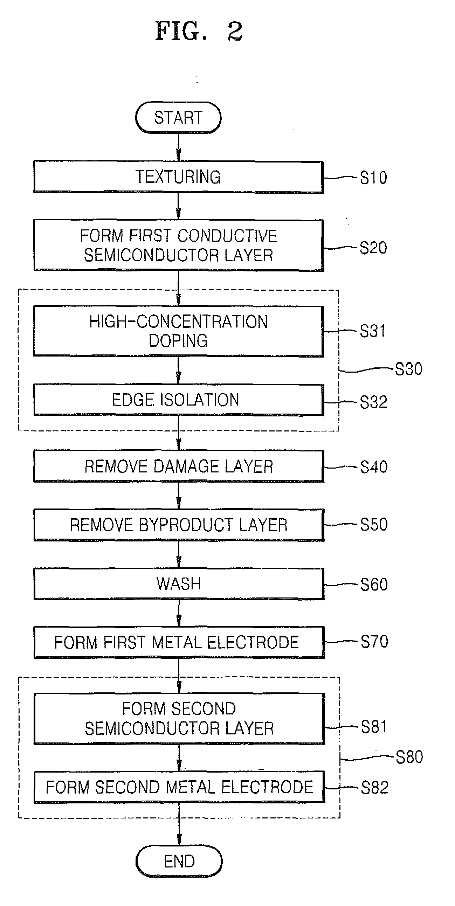

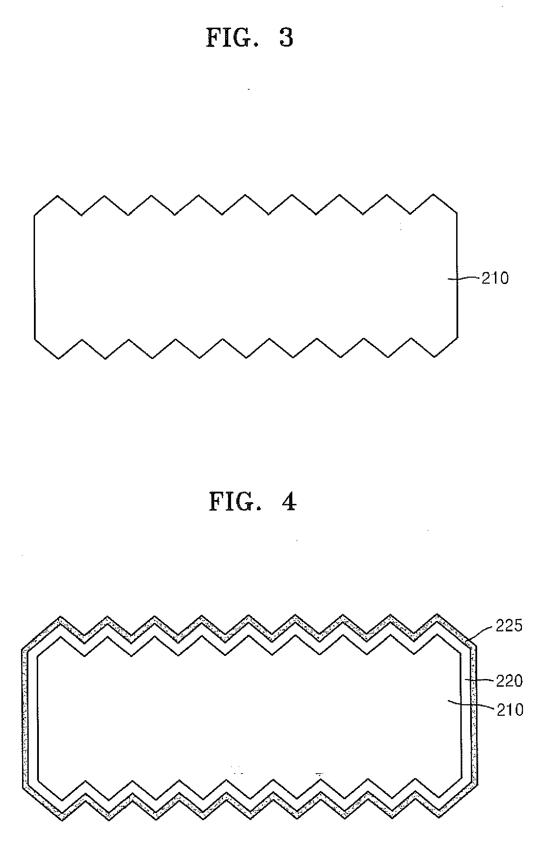

FIG. 2 is a flowchart of a method of manufacturing a photovoltaic device, according to an embodiment of the present invention. FIGS. 3 through 11 are side views for describing states of operations of the flowchart of FIG. 2, according to one or more embodiments of the present invention.

Referring to FIGS. 2 and 3, in operation S10, a texture structure is preferbaly formed on a semiconductor substrate 210. Front and rear surfaces of the semiconductor substrate 210 each have a texture structure, and thus, an optical path of incident light may be increased by the texture structure, thereby increasing light absorption efficiency.

As an example of a texturing process, the semiconductor substrate 210 may preferably be immersed in a solution including a mixture of an isopropyl alcohol (IPA) solution and a solution such as KOH or NaOH. By using this method, the texture structure, e.g., an uneven surface, may preferably be formed to have, for example, a triangular pyramid shape or a rectangular pyramid shape.

The semiconductor substrate 210 may preferably be a p-type silicon substrate or an n-type silicon substrate. Hereinafter, for convenience of description, a case where the semiconductor substrate 210 is a p-type silicon substrate will be described.

Referring to FIGS. 2 and 4, in operation S20, a first conductive semiconductor layer 220 is formed. The first conductive semiconductor layer 220 may preferably be formed by doping the semiconductor substrate 210 with a type of impurity that is different (e.g., an n-type material) from an impurity included in the semiconductor substrate 210.

The first conductive semiconductor layer 220 may preferably be formed by doping the semiconductor substrate 210 with, for example, at least one of group 5 chemical elements. For example, a thermal diffusion method including putting the semiconductor substrate 210 in a furnace, flowing impurities such as, for example, POCl₃ over the semiconductor substrate 210, and then doping the semiconductor substrate 210 with the impurities may preferably be used. While the first conductive semiconductor layer 220 is formed, a byproduct layer 225 such as, for example, a phosphorous silicate glass (PSG) layer may preferably be formed on an edge portion of the first conductive semiconductor layer 220. In an embodiment of the present invention the byproduct layer is preferably formed directly on the first conductive semiconductor layer.

High-concentration doping S31 and edge isolation S32 (collectively, operation S30) may preferably each be performed by using a single laser. In the present embodiment, output of a laser beam for the high-concentration doping may preferably be different from output of a laser beam for the edge isolation.

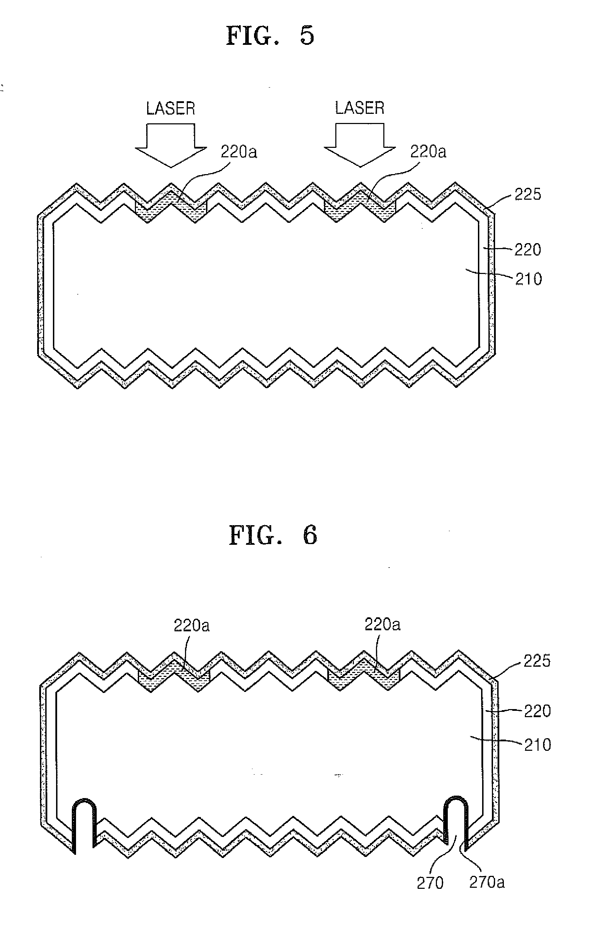

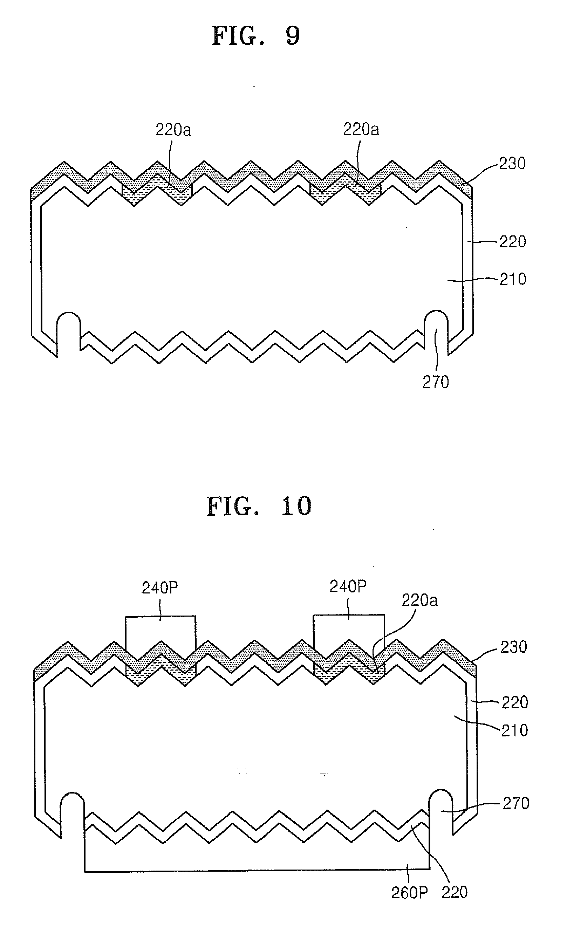

Referring to FIGS. 2 and 5, in operation S31, laser doping may preferably be performed on a region(s) 220a of the first conductive semiconductor layer 220. Accordingly, a group 5 chemical element, e.g., phosphorus (P) included in a PSG layer, that is, the byproduct layer 225, may preferably be further diffused, and/or phosphorus (P) that is already diffused may preferably be highly activated by using a laser. The region 220a of the first conductive semiconductor layer 220, which is doped with a high concentration of a material by using a laser, reduces contact resistance with a first metal electrode 240, and thus, electric charges may be effectively extracted, which will be described with reference to FIG. 10.

Referring to FIGS. 2 and 6, in operation S32, an edge isolation process 32 is performed to form groove portions 270 in edge portions of the rear surface of the semiconductor substrate 210. The groove portions 270 may preferably be formed by laser radiation. Portions of the semiconductor substrate 210, the first conductive semiconductor layer 220, and the byproduct layer 225 may preferably be exposed to the outside through the groove portions 270.

As the edge isolation process 32 using a laser is performed, a damage layer 270a is formed due to a portion of the groove portion 270 being melted by using a high temperature laser, and then hardened. To prevent a shunt from forming due to the damage layer 270a, the damage layer 270a may preferably be removed.

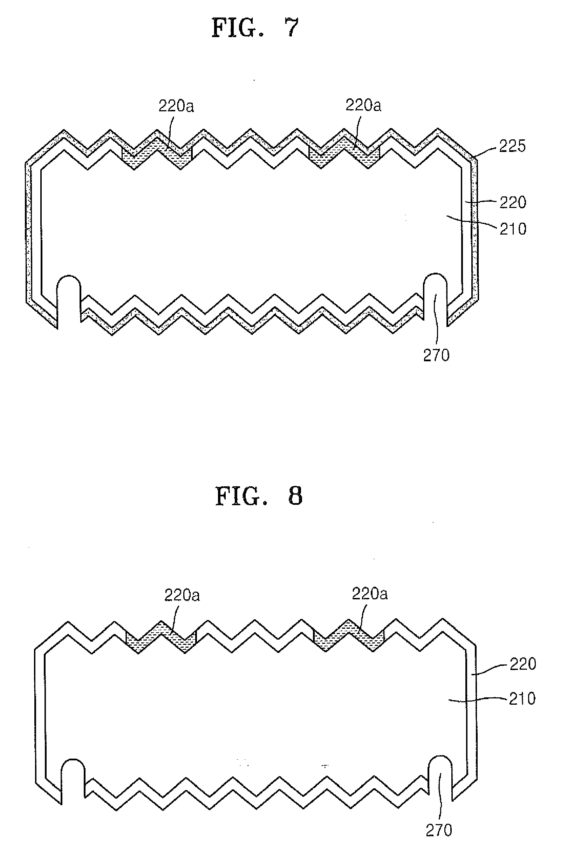

Referring to FIGS. 2 and 7, in operation S40, the damage layer 270a is removed by using a chemical etching method. The damage layer 270a may preferably be removed by an etching method using the byproduct layer 225 as a mask. The etching method may preferably use an alkali solution that may selectively etch the damage layer 270a from among the byproduct layer 225 and the damage layer 270a so as to remove the damage layer 270a. Examples of the alkali solution may include KOH, NaOH, or the like.

Referring to FIGS. 2 and 8, in operation S50, the byproduct layer 225 is removed. The byproduct layer 225 formed of glass such as PSG may preferably be removed by using a wet etching method using a hydrofluoric acid (HF) solution.

Referring to FIG. 2, in operation S60, a washing process may preferably be performed. The washing process S60 may preferably include two operations. First, impurities formed on an entire surface of the semiconductor substrate 210 may be removed by using an etching process using a mixture solution containing nitric acid and hydrofluoric acid (first operation).

During the removal of impurity in the first operation of the washing process S60, an oxide layer may be formed. The oxide layer may preferably be removed by using diluted HF (e.g., in the second operation).

Referring to FIGS. 2 and 9, in operation S70, an antireflection layer 230 is formed. The antireflection layer 230 is formed on the first conductive semiconductor layer 220 from which the impurity and the oxide layer are removed. The antireflection layer 230 may preferably include, for example, SiOx, SiNx, SiOxNy, or the like. Alternatively, the antireflection layer 230 may preferably include, for example, TiO₂, ZnO, ZnS, or the like. The antireflection layer 230 may preferably be formed using a method such as a chemical vapor deposition (CVD) method, a sputtering method, a spin coating method, or the like. In an embodiment of the present invention the antireflection layer is preferably formed directly on the first conductive semiconductor layer.

Referring to FIG. 2, in operation S70, the first metal electrode 240 is formed. In operation S80, a second conductive semiconductor layer 250 and a second metal electrode 260 may preferably be formed. In the present embodiment, operation S81 of forming the second conductive semiconductor layer 250 and operation S82 of forming the second metal electrode 260 may preferably be concurrently (e.g., simultaneously) performed. To this end, a method will be described in detail.

Referring to FIG. 10, metallic pastes 240p and 260p are preferably coated on the first and second metal electrodes 240 and 260. The metallic pastes 240p and 260p may preferably each include elements such as, for example, Ag, Au, Cu, or Al.

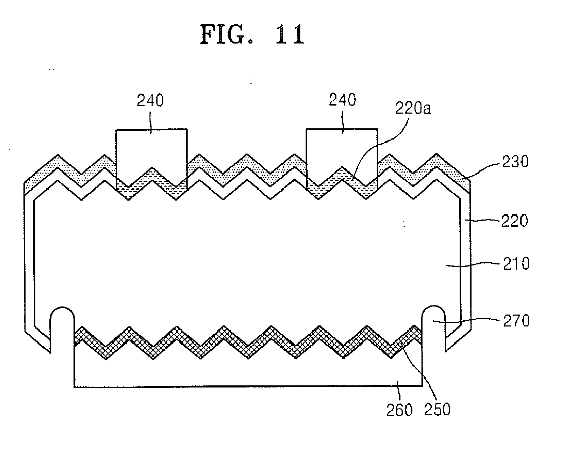

Referring to FIG. 11, the first metal electrode 240 and the second metal electrode 260 are completely formed by firing the metallic pastes 240p and 260p. The metallic paste 240p for forming the first metal electrode 240 may preferably electrically contact the first conductive semiconductor layer 220 through the antireflection layer 230 by a firing process.

The second conductive semiconductor layer 250 may preferably also be formed together with the second metal electrode 260 by using the firing process. For example, the metallic paste 260p for forming the second metal electrode 260 may preferably act as a p-type impurity so that a rear surface of the semiconductor substrate 210 may preferably be doped with a p+ type (or p++ type) material. The second conductive semiconductor layer 250 forms a back surface field (BSF). As such, since the second conductive semiconductor layer 250 and the second metal electrode 260 are concurrently (e.g., simultaneously) formed, the second conductive semiconductor layer 250 and the second metal electrode 260 may preferably include the same element, that is, for example, a group 3 metal element such as Al.

In the above-described manufacturing method, the first conductive semiconductor layer 220 is preferably formed by using a p-type silicon substrate as the semiconductor substrate 210 and using a group 3 chemical element as impurities. However, embodiments of the present invention are not limited to this structure. For example, the first conductive semiconductor layer 220 may preferably be formed by using an n-type silicon substrate as the semiconductor substrate 210 and using a group 5 chemical element as impurities. In this case, a photovoltaic device is manufactured in the same manner, except that the byproduct layer 225 is formed on an edge portion of the first conductive semiconductor layer 220 as a boron-silicate glass (BSG) layer.

As described with reference to FIGS. 2 through 12, in the method of manufacturing a photovoltaic device according to an embodiment of the present invention, the high concentration doping process S31 and the edge isolation process S32 may preferably be concurrently (e.g., simultaneously) performed by using a laser, thereby reducing the number of processes.

The damage layer 270a included in the groove portions 270 formed by using the edge isolation process S32 may preferably be removed by using a chemical etching method. In this case, since a PSG layer, that is, the byproduct layer 225, is used as a mask, a separate mask does not have to be formed.

Since the groove portions 270 are formed in the rear surface of the photovoltaic device, the current photoelectric conversion efficiency of the photovoltaic device may be increased as compared to a situation where the groove portions are formed in a front surface of the photovoltaic device.

Hereinafter, characteristics of photovoltaic devices according to embodiments of the present invention will be described with reference to Comparative Examples and Examples.

Table 1 below shows Comparative Examples 1 and 2, in which a process for forming groove portions by using an edge isolation process using a laser and chemical etching is not performed. However, Comparative Example 1 shows a case where the edge isolation process using a laser is performed after a firing process is performed. Comparative Example 2 shows a case where the edge isolation process using a laser is performed after a first conductive semiconductor layer is formed (e.g., a diffusion process). Accordingly, Comparative Example 1 is formed by the following steps: Forming a first conductive semiconductor layer → removing PSG → forming antireflection layer → printing paste and firing the paste to form a metal electrode → front laser isolation and Comparative Example 2 is formed by the following steps: Forming a first conductive semiconductor layer → front laser isolation → removing PSG → forming antireflection layer → printing paste and firing the paste to form a metal electrode. In Comparative Examples 1 and 2, the groove portions are formed in a front surface of the photovoltaic device.

**Table 1**

| | Jsc (mA/sq) | Voc (mV) | Eff. (%) | FF (%) | Rs (ohm-sq) | Rsh (ohm-sq) | n (diode factor) |
|---|---|---|---|---|---|---|---|
| Comparative Example1 | 36.48 | 632.9 | 18.43 | 79.8 | 0.4402 | 721,978 | 1.09 |
| Comparative Example 2 | 36.67 | 632.7 | 18.58 | 80.1 | 0.3789 | 2,691 | 1.09 |

| | | | | | | | |
|---|---|---|---|---|---|---|---|
| Rs - series resistance of the equivalent circuit of a solar cell, the lower Rs the better the properties. Rsh - shunt resistance of the equivalent circuit of a solar cell, the greater Rsh the better the properties. | | | | | | | |

In Comparative Example 1 and Comparative Example 2, it may be confirmed that a current density (Jsc), efficiency (Eff.), and a fill factor (FF) are increased when the edge isolation process using a laser is performed after doping is performed. The same result may be obtained when groove portions are formed in a rear surface of a photovoltaic device.

Table 2 below shows Comparative Example 3, in which an edge isolation process using a laser is performed after a first conductive semiconductor layer is formed (e.g., a diffusion process) and chemical etching is not performed. Table 2 also shows "Example," in which groove portions are formed by using an edge isolation process using a laser after doping is performed on a first conductive semiconductor layer and a damage layer is removed by using a chemical etching method, as in a photovoltaic device according to embodiments of the present invention. Accordingly, Comparative Example 3 is formed by the following steps: forming a first conductive semiconductor layer → Front laser isolation → removing PSG → forming antireflection layer → printing paste and firing the paste to form a metal electrode and Example 1 is formed by the following steps: Forming a first conductive semiconductor layer → Laser doping and Front laser isolation → removing PSG → Etching the damaged layer → Washing diluted HF → forming antireflection layer → printing paste and firing the paste to form a metal electrode.

**Table 2**

| | Jsc(mA/sq) | Voc(mV) | Eff. (%) | FF(%) | Rs(ohm-sq) | Rsh(ohm-sq) | n(diode factor) |
|---|---|---|---|---|---|---|---|
| Comparative Example 3 | 37.23 | 640.2 | 19.17 | 80.5 | 0.4436 | 4,260 | 1.05 |
| Example | 37.49 | 640.9 | 19.30 | 80.3 | 0.4534 | 5,338 | 1.05 |

According to Comparative Example 3 and Example, it may be confirmed that a short-circuit current density (Jsc) and efficiency (Eff.) are increased by using a process in which groove portions are formed in a rear surface of a photovoltaic device, but not formed in a front surface, and a damage layer formed on the groove portions is removed by using a chemical etching process.

As described above, according to the one or more of the above embodiments of the present invention, while a photovoltaic device is manufactured, the high concentration doping process and the edge isolation process may preferably be concurrently (e.g., simultaneously) performed by using a laser, thereby reducing the number of processes.

In addition, since groove portions are preferably formed by using a laser and a damage layer is removed by a chemical etching method, the electrical properties and the efficiency of a photovoltaic device may be improved.

Further, since groove portions are formed in a rear surface of a photovoltaic device, a passivation effect of an antireflection layer may be increased, thereby improving the current properties of the photovoltaic device.

It should be understood that the embodiments described herein should be considered in a descriptive sense only, and should not be considered for purposes of limitation. Descriptions of features or aspects within each embodiment should typically be considered as available for other similar features or aspects in other embodiments. It will be understood by those of ordinary skill in the art that features of different embodiments may be combined to form further embodiments, and that various changes, modifications and adaptations in form and details of the invention are possible without departure from the scope of the invention. Thus the present invention has been described by way of illustration and not limitation, and is defined by the following claims and their equivalents.

## Claims

1. A method of manufacturing a photovoltaic device, the method comprising:
performing edge isolation to form a groove portion at an edge portion of a rear surface of a semiconductor substrate, optionally using a laser; and
etching a damage layer formed during the edge isolation on the groove portion.

2. The method of claim 1, further comprising forming a first conductive-type semiconductor layer using a first impurity applied to the semiconductor substrate and, wherein a byproduct layer is also formed during formation of the first conductive-type semiconductor layer, wherein the byproduct layer acts as a mask during the etching of the damage layer.

3. The method of claim 1 or claim 2, wherein the etching comprises wet-etching the damage layer using an alkali solution.

4. The method of claim 2 or claim 3, further comprising removing the byproduct layer after the etching.

5. The method of any of claims 1 to 4, further comprising performing doping a region of the first conductive-type semiconductor layer using a laser and forming a first metal electrode on the front surface of the semiconductor substrate, wherein the region of the first conductive-type semiconductor layer corresponds to the first metal electrode.

6. The method of any of claims 1 to 5, further comprising forming an antireflection layer on a front surface of the semiconductor substrate and optionally washing the front surface of the semiconductor substrate prior to forming the antireflection layer.

7. The method of claim 6, wherein the washing comprises:
a first operation of removing impurities using a mixture solution comprising nitric acid and hydrofluoric acid; and
a second operation of removing an oxide layer remaining after the first operation using diluted HF.

8. The method of any of claims 1 to 7, further comprising forming a second metal electrode and a second conductive-type semiconductor layer comprising a second impurity that is different from the first impurity, on the rear surface of the semiconductor substrate.

9. The method of claim 8, wherein forming the second metal electrode and the second conductive-type semiconductor layer comprises:
coating metallic pastes on the rear surface of the semiconductor substrate; and
using a firing method to concurrently form the second metal electrode and the second conductive-type semiconductor layer.

10. A photovoltaic device manufactured using the method of any of claims 1 to 9.

11. A photovoltaic device comprising:
a semiconductor substrate;
a first conductive-type semiconductor layer on a front surface of the semiconductor substrate and a lateral surface of the semiconductor substrate, the first conductive-type semiconductor layer being doped with a first impurity;
a second conductive-type semiconductor layer on a rear surface of the semiconductor substrate, the second conductive-type semiconductor layer being doped with a second impurity that is different from the first impurity; and
a groove portion at an edge portion of the semiconductor substrate that is configured to electrically isolate the first conductive-type semiconductor layer from the second conductive-type semiconductor layer,
wherein a portion of the first conductive-type semiconductor layer is doped with the first impurity at a higher concentration than a remaining portion of the first conductive-type semiconductor layer.

12. The photovoltaic device of claim 11, wherein portions of the semiconductor substrate, the first conductive-type semiconductor layer, and the second conductive-type semiconductor layer are exposed to the outside through the groove portion.

13. The photovoltaic device of claim 11 or claim 12, further comprising a first metal electrode on a portion of the first conductive-type semiconductor layer.

14. The photovoltaic device of any of claims 11 to 13, further comprising an antireflection layer on the first conductive-type semiconductor layer.

15. The photovoltaic device of any of claims 11 to 14, further comprising a second metal electrode on the second conductive-type semiconductor layer, the second metal electrode comprising a same chemical element as that of the second impurity.

16. The photovoltaic device of any of claims 11 to 15, wherein the semiconductor substrate is a second conductive-type.

17. The photovoltaic device of any of claims 11 to 16, wherein the semiconductor substrate comprises a textured surface.
